# EUROPEAN PATENT APPLICATION

(11) **EP 1 049 221 A1**
(43) Date of publication of application: **02.11.2000**
(21) Application number: 99970516.3
(22) Date of filing: 12.10.1999
(51) Int. Cl.: H01S 5/223

(54) **SEMICONDUCTOR LASER DEVICE**

(30) Priority: 15.10.1998 JP 29341798
(71) Applicant: The Furukawa Electric Co., Ltd., Tokyo 100-8322 (JP)
(72) Inventor: IWAI, Norihiro-The Furukawa Electric Co., Ltd., Tokyo 100-8322 (JP); MUKAIHARA, Toshikazu-The Furukawa Electric Co., Lt, Tokyo 100-8322 (JP); KASUKAWA, Akihiko-The Furukawa Electric Co., Ltd., Tokyo 100-8322 (JP); SHIMIZU, Hitoshi-The Furukawa Electric Co., Ltd., Tokyo 100-8322 (JP)
(74) Representative: Pätzold, Herbert, Dr.-Ing.
(86) International application number: JP9905622
(87) International publication number: WO0022706

(57) **Abstract**

A semiconductor laser device (20) has a multilayer structure including an n-InP clad layer (22), a SCH-MQW active layer (23), a first p-InP clad layer (24), a multilayer film (25) of p-AllInAs layer/p-AlAs layer, a second p-InP clad layer (26), and a p-GaInAs contact layer (27), all formed in multilayer on an n-InP substrate (21). The multilayer film (25) has a structure in which p-AllInAs layers (25a) and p-AlAs layers (25b) are alternated. Of the multilayer structure, the upper portion of the first p-InP clad layer, the multilayer film, the second p-InP clad layer, and the p-GaInAs contact layer are formed into stripelike ridges (32) having widths of about 10 µm. The side walls of the ridges of the multilayer film is an Al oxide layer (28) formed by selective oxidation of Al in the multilayer film. Thus, a semiconductor laser device having a current/optical confinement structure by virtue of an Al oxide layer on an InP substrate is provided.

## Description

### FIELD OF THE INVENTION

The present invention relates to an InP group semiconductor laser device having a current confinement structure using an oxidized Al layer and, more particularly, the InP group semiconductor laser device having an excellent laser performance and a structure for allowing high-yield production.

### BACKGROUND OF THE INVENTION

It is usual that, in a semiconductor laser device, a semiconductor layer containing Al is formed as a part of the laminated structure of a luminous region. An oxidized Al layer is formed by selectively oxidizing the Al in the semiconductor layer containing Al, and thus formed oxidized Al layer is used as a current-blocking layer or a current confinement structure. Although the current confinement structure using the oxidized Al layer is most often applied to a GaAs group surface-emission-type semiconductor laser device, it is now being applied to a GaAs group edge-emission-type semiconductor laser device.

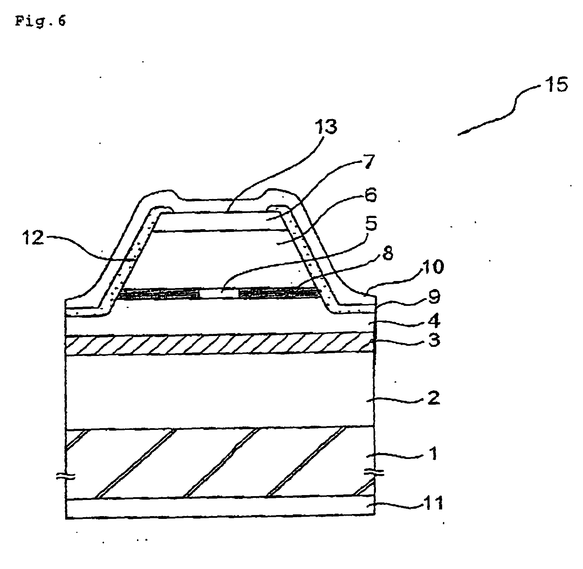

The structure of a conventional GaAs group edge-emission-type semiconductor laser device using an oxidized Al layer as a current-blocking layer is described below with reference to Fig. 6. Fig. 6 is a schematic sectional view of a conventional GaAs group edge-emission-type semiconductor laser device.

Conventionally, the GaAs group edge-emission-type semiconductor laser device 15 has, as shown in Fig. 6, an n-GaAs substrate 1 having a thickness of about 100 µm, and a laminated structure including n-AlGaAs cladding layer 2, active layer 3, first p-AlGaAs cladding layer 4, p-AlAs layer 5, second p-AlGaAs cladding layer 6 and p-GaAs contact layer 7, which are consecutively formed on the n-GaAs substrate 1.

The top portion of the first p-AlGaAs cladding layer 4, the p-AlAs layer 5, the second p-AlGaAs cladding layer 6, and the p-GaAs contact layer 7 in the laminated structure are configured to form a striped ridge 12 having a width of about 20 µm.

In addition, the ridge sides of the p-AlAs layer 5 are formed as oxidized Al layers 8 in which Al is selectively oxidized. On the ridge except for an opening 13 formed on the top of the ridge, a SiNₓ film 9 is formed as a protecting film. A p-type electrode 10 is formed on the SiNₓ film 9 including the opening 13 on the top of the ridge, and an n-type electrode 11 was formed on the bottom surface of the n-GaAs substrate 1.

In the semiconductor laser device 15, since the oxidized Al layer 8 is formed as an Al₂O₃ film which has an electrically insulating property and a refractive index as low as 1.6, an excellent confinement structure is formed which allows both current and optical confinements by the oxidized Al film 8.

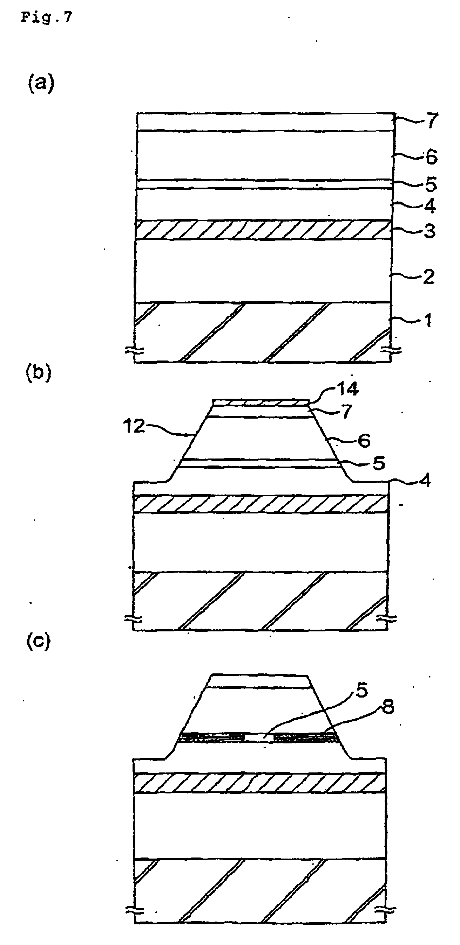

A method for fabricating the conventional semiconductor laser device 15 is described below with reference to Figs. 7a to 7c. Figs. 7a-7c are sectional views of the wafer for showing consecutive steps of a process for fabricating the conventional semiconductor laser device 15.

Firstly, on an n-GaAs substrate 1, an n-AlGaAs cladding layer 2, an active layer 3, a first p-AlGaAs cladding layer 4, a p-AlAs layer 5, a second p-AlGaAs cladding layer 6, and a p-GaAs contact layer 7 are consecutively formed by a MOCVD method to provide a laminated structure as shown in Fig. 7a.

Subsequently, a mask 14 made of SiO₂ is formed on the contact layer 7, followed by etching, by using the mask 14, for removal of the contact layer 7, the second p-AlGaAs cladding layer 6, the p-AlAs layer 5, and a part of the first p-AlGaAs cladding layer 4, thereby forming a striped ridge 12 having a width of 20 µm, as shown in Fig. 7b.

Thereafter, the mask 14 is removed, and Al of the p-AlAs layer 5 is selectively oxidized from the sides of the ridge by a thermal treatment using steam at about 400°C for five minutes to form the oxidized Al layer 8, as shown in Fig. 7c. Then, on the ridge except for the opening 13 on the top of the ridge, a SiNₓ film 9 is formed as a protecting film, as shown in Fig. 6. Then, the n-GaAs substrate 1 is polished at the bottom surface thereof to have a thickness of about 100 µm, followed by depositing a p-type electrode 10 on the SiNₓ film 9 including the opening 13 on the top of the ridge and an n-type electrode 11 on the bottom surface of the n-GaAs substrate 1.

Although the above process for fabricating a semiconductor laser device is basically similar to that for fabricating a usual edge-emission ridge-type semiconductor laser device except for the formation of the confinement structure 4, the conventional method has the following advantages.

Specifically, the confinement structure can be formed in a single crystal growth step and a single oxidation step in which the AlAs layer 5 is epitaxially grown and oxidized. Thus, the fabrication process is simpler compared to the usual method for forming the confinement structure wherein a p-type semiconductor layer and an n-type semiconductor layer are deposited for embedding the ridge structure and for isolation by using a reverse-biased p-n junction. Thus, the described fabrication process is expected to achieve a higher production yield and a lower device cost.

If the confinement structure having the above-mentioned structure is to be applied to a device formed on an InP substrate, however, it is difficult to use an AlAs layer in an InP group semiconductor laser device, because the AlAs layer has a mismatch ratio of about 3.5% against the InP layer.

On the other hand, AlInAs is known as a material which has an Al content and thus can be used as a lattice-matching material to be laminated on the InP substrate. It is also known that since it has a low Al content as low as about 50%, the oxidation rate thereof is low and not suited for practical use. Although it is possible to raise the temperature of the heat treatment for the Al oxidation to accelerate the Al oxidation rate, there is a problem in that the exposed sides of the ridge assume rough surfaces if the temperature of the heat treatment is raised to 500°C or above.

### SUMMARY OF THE INVENTION

It is an object of the present invention to provide a semiconductor laser device formed on the InP substrate having a current and optical confinement structure using an oxidized Al layer.

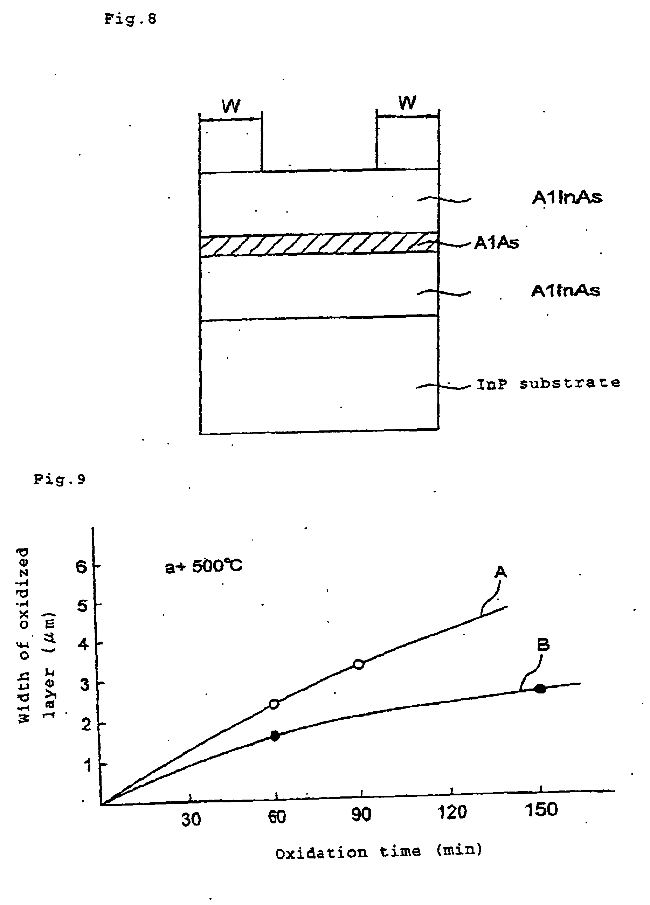

The inventors noticed the structure of a multi-layered film having an AlAs layer interposed between AlInAs layers that are suitably lattice-matched with the InP substrate, the AlAs layer having an excellent oxidization property to accelerate oxidation. Thus, sample A having a structure of three laminated layers as shown in Fig. 8 was fabricated by a MOCVD method, wherein the structure having a lower AlInAs layer, an AlAs layer having a thickness of 2 nm and an upper AlInAs layer consecutively is formed on the InP substrate to obtain a total thickness of 50nm for the upper and lower AlInAs layers.

Then, an oxidation test was conducted to the AlInAs layers in the multi-layered film of the sample A at an oxidation temperature of 500°C, from which test the relations between oxidation time and the width "W" of the oxidized Al layer were obtained. The width "W" of the oxidized Al layer was measured from the periphery toward the center of the sample, as shown in Fig. 8. The results of the test are shown as a curve A in Fig. 9, wherein the oxidation time (minutes) is plotted on abscissa and the width (µ m) of the oxidized Al layer after oxidation is plotted on ordinate.

For comparison, another sample B having a 50-nm-thick AlInAs layer was formed on the InP substrate, and was subjected to the oxidation test under the same condition as the sample A. In Fig. 9, curve B depicts the result of the test for the sample B.

As understood from Fig. 9, by interposing the AlAs layer between the AlInAs layers, the oxidation rate was increased to about 1.5 times, which rate is more practical and economical in actual operations.

It was also confirmed that the thickness of the AlAs layer is preferably between 2nm and 5nm, although outside the range causes no problem in the crystal growth itself so long as the thickness is less than the critical film thickness. The thickness of the AlInAs layer is preferably 20nm or more in order to have an effective current-blocking layer. It was also confirmed that the three-layered film including the AlInAs layer, the AlAs layer, and the AlInAs layer and deposited by a MBE method or a gas source MBE method proved an effective result comparable to that formed by the MOCVD method. In addition, instead of the AlAs layer, an AlGaAs Layer having a larger Al content proved a similar result.

In order to achieve the above object, based on the above findings, a semiconductor laser device according to the present invention includes a lower cladding layer, an active layer, and an upper cladding layer, which are consecutively deposited on an InP substrate, at least said upper cladding layer being configured as a striped ridge or a mesa post forming a part of a semiconductor laminated structure, characterized by:
a current confinement layer disposed between a pair of p-type cladding layers or between a p-type cladding layer and the active layer, the current confinement layer having a multi-layered film structure wherein at least one p-type AlInAs layer and at least one p-type AlAs layer are consecutively deposited, the current confinement layer including a central region and a peripheral region wherein Al in the multi-layered structure is selectively oxidized to form an oxidized Al layers.

According to the present invention, oxidation rate of the AlInAs layer overlying the InP substrate can be increased by an oxidation-assisting effect of the AlAs layer due to the multi-layered film including the AlInAs layer and the AlAs layer as an Al-containing semiconductor layer. Thus, an InP group semiconductor laser device having the confinement structure using the oxidized Al layer can be economically produced.

In the present invention, the current confinement layer obtained by the oxidized Al layer is formed on the p-side because the current can be efficiently confined when formed on the p-side.

The number of the AlInAs layers in the multi-layered film in the present invention is not limited. In addition, the number of the AlAs layers interposed between the AlInAs layers, or disposed adjacent to the AlInAs layer depends on the number of the AlInAs layers.

The present invention can be applied to both the edge-emission-type and the surface-emission-type semiconductor laser devices so long as they belong to the InP group semiconductor devices.

### BRIEF DESCRIPTION OF THE DRAWINGS

Fig. 1 is a sectional view showing a laminated structure of a semiconductor laser device of Embodiment 1.
Fig. 2 is a sectional view showing the structure of a multi-layered film.
Figs. 3a-3c are sectional views of the substrate showing the laminated structure in consecutive steps of a process for fabricating the semiconductor laser device of Embodiment 1.
Fig. 4 is a sectional view showing the laminated structure of a semiconductor laser device of Embodiment 2.
Figs. 5a-5c are sectional views of a wafer showing the laminated structure in consecutive steps of a process for fabricating the semiconductor laser device of Embodiment 2.
Fig. 6 is a sectional view showing a laminated structure of a conventional GaAs group semiconductor laser device.
Figs. 7a-7c are sectional views of a wafer showing the laminated structure in consecutive steps of a process for fabricating the conventional GaAs group semiconductor laser device.
Fig. 8 is a sectional view showing a laminated structure of a sample for the oxidation test.
Fig. 9 is a graph showing relations between the oxidation time and the width of the oxidized layer of the sample.

### PREFERRED EMBODIMENTS OF THE INVENTION

In a preferred embodiment of the present invention, the total thickness of the AlInAs layers is determined between 20 nm and 200 nm. The reason for employing "20 nm and 200 nm" for the thickness of the AlInAs layers in the preferred embodiment is as follows. A remarkable current-blocking effect can be obtained by a thickness having 20 nm or more, whereas if the thickness is larger than 200 nm, the current-blocking effect reaches the upper limit. It is ineffective to increase the film thickness above 200 nm.

In another preferred embodiment of the present invention, the thickness of each AlAs layer in the multi-layered film is between 2 nm and 5 nm. An effective oxidation-assisting layer can be obtained by controlling the thickness of the AlAs layer between 2 nm and 5 nm while preventing the distortion due to lattice-mismatching.

Now, concrete Embodiments of the present invention are described in detail with reference to the attached drawings.

### Embodiment 1

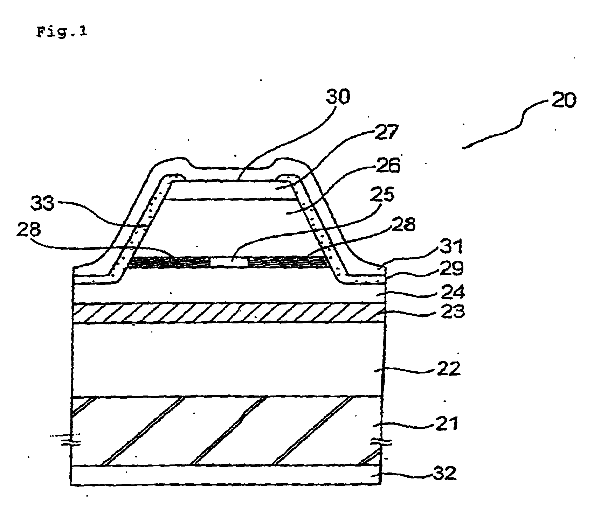

The present embodiment is an example of the semiconductor laser device of the present invention applied to a semiconductor laser device formed on an n-InP substrate. Fig. 1 is a sectional view of the laminated structure of the semiconductor laser device of the present embodiment.

As shown in Fig. 1, the semiconductor laser device 20 of the present embodiment has an n-InP substrate 21 having a thickness of about 100 µm, and a laminated structure including an n-InP cladding layer 22, a SCH-MQW active layer 23, a first p-InP cladding layer 24, a p-AlInAs/p-AlAs multi-layered film 25, a second p-InP cladding layer 26, and a p-GaInAs contact layer 27 which are consecutively formed on the n-InP substrate 21.

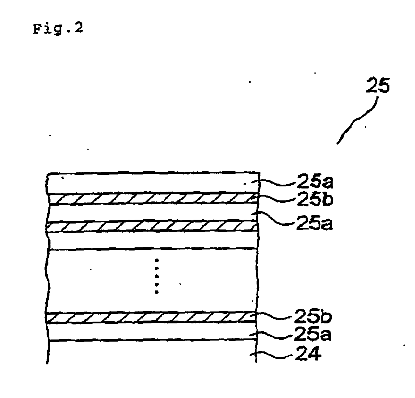

As shown in Fig. 2, in the multi-layered film 25 having p-AlInAs layer/p-AlAs layer structure, a p-AlAs layer 25b is interposed between p-AlInAs layers 25a. In the present embodiment, the number of p-AlInAs layers 25a is five.

In the present embodiment, the n-InP cladding layer 22 corresponds to the lower cladding layer having the same conductive type as the conductive type of the semiconductor substrate in the semiconductor laser device of the present invention, whereas the first p-InP cladding layer 24 and the second p-InP cladding layer 26 correspond to the upper cladding layer having the conductivity type opposite to the conductive type of the semiconductor substrate.

In the laminated structure, the top portion of the first p-InP cladding layer 24, the multi-layered film 25 having a p-AlInAs/p-AlAs film structure, the second p-InP cladding layer 26, and the p-GaInAs contact layer 27 are configured as a striped ridge 33 having a width of about 10 µm. In addition, the ridge sides of the p-AlInAs/p-AlAs multi-layered film 25 are the oxidized Al layers 28.

A SiNₓ film 29 is deposited as a protecting film on the striped ridge except for the opening 30 thereof exposing the top of the ridge. In addition, a p-type electrode 31 is formed on the SiNₓ film 29 including the opening 30 on the top of the ridge, and an n-type electrode 32 is deposited on the bottom surface of the n-InP substrate 21.

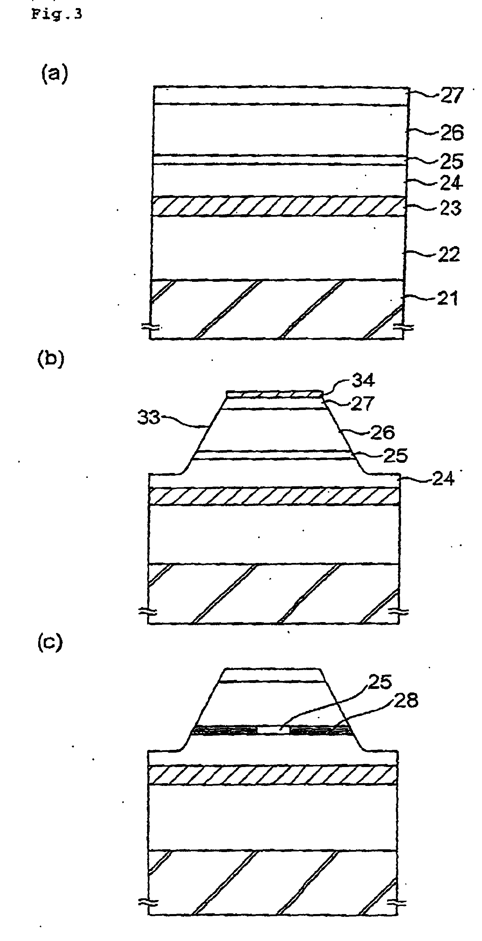

A method for fabricating a semiconductor laser device of the present embodiment is described with reference to Figs. 3a to 3c. Figs. 3a-3c are sectional views of a wafer for showing a laminated structure in consecutive steps of a process for fabricating the semiconductor laser device according to the present embodiment.

Firstly, as shown in Fig. 3a, a laminated structure having the n-InP cladding layer 22, the SCH-MQW active layer 23, the first p-InP cladding layer 24, the p-AlInAs/p-AlAs multi-layered film 25, the second p-InP cladding layer 26, and the p-GaInAs contact layer 27 are consecutively grown by a MOCVD method on the n-InP substrate 21.

As shown in Fig. 2, during formation of the multi-layered film 25, the p-AlInAs layer 25a is first deposited on the first p-InP cladding layer 24. Thereafter, the p-AlAs layer 25b and the p-AlInAs layer 25a are alternately grown, and finally the p-AlInAs layer 25a is grown.

Subsequently, a SiO₂ film is formed on the contact layer 27, and a striped mask 34 is formed by patterning. Then, by using the mask 34, the contact layer 27, the second p-InP cladding layer 26, and the multi-layered film 25 are removed by etching. Thereafter, as shown in Fig. 3b, the top portion of the second p-InP cladding layer 24 is removed by etching to configure a striped ridge 33 having a width "W" of 10 µm.

Subsequently, while the mask 34 made of SiO₂ used for etching is used as an oxidation-prevention mask for the surface of the p-GaInAs layer 27, a heat treatment is conducted for 90 minutes in steam at about 500° C, thereby oxidizing the p-AlInAs/p-AlAs multi-layered film 25 from the sides of the ridge 32. Thus, Al therein is selectively oxidized to form the oxidized Al layers 28.

Next, as shown in Fig. 1, the SiNₓ film 29 is formed on the region except for the top of the ridge, after the mask 34 made of SiO₂ is removed. Then, the n-InP substrate 21 is polished so as to have a thickness of about 100 µm. The p-type electrode 31 is then deposited on the SiNₓ film 29 and in the opening 30, and the n-type electrode 32 is deposited on the bottom surface of the n-InP substrate 21.

The InP group semiconductor laser device according to the present embodiment provides a current/optical confinement function due to the oxidized Al layer, similarly to a semiconductor laser device fabricated on a GaAs substrate.

In addition, the oxidation-assisting effect of the AlAs layer accelerates the oxidation rate of the AlInAs layer overlying the InP substrate, and facilitate the formation of the current/optical confinement structure having the oxidized Al layer.

### Embodiment 2

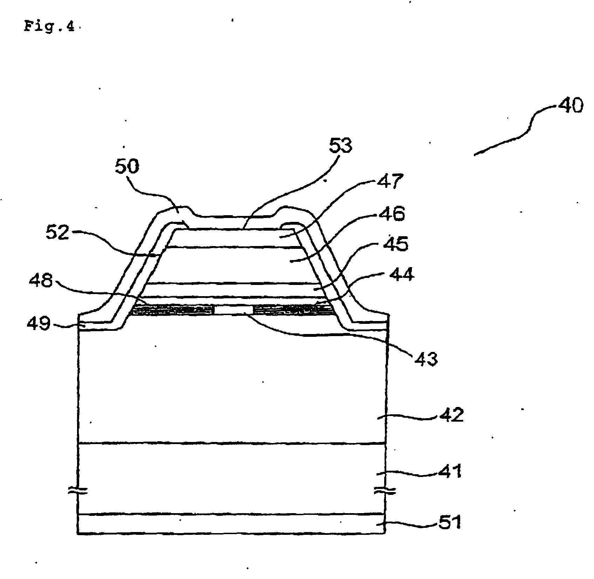

The present embodiment is another example of the semiconductor laser device of the present invention applied to a semiconductor laser device formed on a p-InP substrate. Fig. 4 is a sectional view of a laminated structure of a semiconductor laser device of the present embodiment.

As shown in Fig. 4, the semiconductor laser device 40 according to the present embodiment includes a p-InP substrate 41 having a thickness of about 100 µm, and a laminated structure including a first p-InP cladding layer 42, a p-AlInAs/p-AlAs multi-layered film 43, a second p-InP cladding layer 44, a SCH-MQW active layer 45, an n-InP cladding layer 46, and an n-GaInAs contact layer 47 which are consecutively formed on the p-InP substrate 41.

The p-AlInAs/p-AlAs multi-layered film 43 has a structure similar to the structure of the multi-layered film 25 shown in Fig. 2.

In the present embodiment, the first p-InP cladding layer 42 and the second p-InP cladding layer 44 correspond to the lower cladding layer having the same conductive type as the conductivity type of the semiconductor substrate in the present invention, whereas the n-InP cladding layer 40 corresponds to the upper cladding layer having a conductivity type opposite to the conductive type of the semiconductor substrate.

In the laminated structure, the top portion of the first p-InP cladding layer 42, the p-AlInAs/p-AlAs multi-layered film 43, the second p-InP cladding layer 44, the active layer 45, the n-InP cladding layer 46, and the p-GaInAs contact layer 47 are configured as a striped ridge 52 having a width of about 10 µm.

The ridge sides of the p-AlInAs/p-AlAs multi-layered film 43 are formed as oxidized Al layers 48 in which Al in the multi-layered film 43 is selectively oxidized. On the region except for an opening 53 on the top of the ridge, a SiNₓ film 49 is formed as a protection film. In addition, a p-type electrode 50 is deposited on the SiNₓ film 49 including the region of the opening 53 on the top the ridge, and an n-type electrode 51 is deposited on the bottom surface of the p-InP substrate 41.

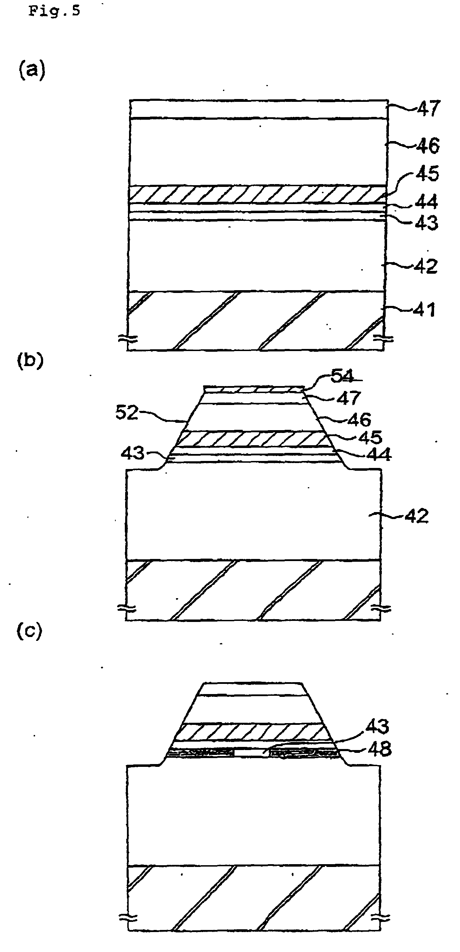

A method for fabricating the semiconductor laser device of the present embodiment is described below with reference to Figs 5a to 5c. Figs. 5a-5c are sectional views of a wafer for showing a laminated structure in consecutive steps of a process for fabricating the semiconductor laser device of the present embodiment.

Firstly, as shown in Fig. 5a, the first p-InP cladding layer 42, the p-AlInAs/p-AlAs multi-layered film 43, the second p-InP cladding layer 44, the SCH-MQW active layer 45, the n-InP cladding layer 46, and the p-GaInAs contact layer 47 are consecutively deposited on the p-InP substrate 41, by a MOCVD method to form the laminated structure. The multi-layered film 43 is formed in a manner similar to the manner for the multi-layered film 25 in Embodiment 1.

Subsequently, a SiO₂ film is deposited on the contact layer 47, and a striped mask 54 is formed by patterning. Then, as shown in Fig. 5b, by using the mask 54, the contact layer 47, the p-InP cladding layer 46, the active layer 45, the second p-InP cladding layer 44, and the multi-layered film 43 are removed by etching. Then, a part of the first p-InP cladding layer 42 is removed by etching to form the striped ridge 52 having a width (W) of 10 µm.

Subsequently, by using the mask 54 made of SiO₂ used for etching as an oxidation prevention mask, a heat treatment is conducted for 90 minutes in steam at about 500°C, thereby selectively oxidizing Al in the p-AlInAs/p-AlAs multi-layered film 43 from the sides or peripheries of the ridge 52. Thus, Al is selectively oxidized to form the oxidized Al layers 48.

Next, as shown in Fig. 4, after the mask 54 made of SiO₂ is removed, the SiNₓ film 49 is formed on the region except for the top of the ridge. Then, the n-InP substrate 41 is polished so as to have a thickness of about 100 µm, followed by deposition of the n-type electrode 50 on the SiNₓ film 49 and the opening 53, and the p-type electrode 51 on the bottom surface of the p-InP substrate 41.

The InP group semiconductor laser device of the present embodiment provides a current/optical confinement function due to the oxidized Al layer, similarly to a semiconductor laser device fabricated on a GaAs substrate.

In addition, the oxidation-assisting effect of the AlAs layer accelerates the oxidation rate of the AlInAs layer overlying the InP substrate, and facilitates formation of the current/optical confinement structure having the oxidized Al layer.

Although edge-emission-type laser devices each having a striped ridge are described in the above embodiments, the present invention can be applied to surface-emission-type laser devices having mesa posts as well.

## Claims

1. A semiconductor laser device comprising a lower cladding layer, an active layer, and an upper cladding layer, which are consecutively grown on an InP substrate, at least said upper cladding layer being configured as a striped ridge or a mesa post forming a part of a semiconductor laminated structure, characterized by:
a current confinement layer disposed between a pair of p-type cladding layers or between a p-type cladding layer and the active layer, the current confinement layer having a multi-layered film structure wherein at least one p-type AlInAs layer and at least one p-type AlAs layer are consecutively deposited, the current confinement layer including a central region and a peripheral region wherein Al in the multi-layered structure is selectively oxidized to form an oxidized Al layer.

2. The semiconductor laser device as defined in claim 1, wherein a total thickness of the at least one AlInAs layer is between 20 nm and 200 nm.

3. The semiconductor laser device as defined in claim 1 or 2, wherein the at least one AlAs layer has a thickness between 2 nm and 5nm for each single layer.
